# EUROPÄISCHE PATENTSCHRIFT

(11) **EP 0 601 974 B1**
(45) Veröffentlichungstag und Bekanntmachung des Hinweises auf die Patenterteilung: **28.05.1997**
(21) Anmeldenummer: 93810824.8
(22) Anmeldetag: 25.11.1993
(51) Int. Cl.: C08F 222/40, C08F 212/14, G03F 7/039

(54) **Positiv-Photoresist mit verbesserten Prozesseigenschaften**
Positive photoresist with better properties
Photoréserve positive avec des propriétés améliorés

(30) Priorität: 04.12.1992 CH 3723/92
(43) Veröffentlichungstag der Anmeldung: 15.06.1994
(73) Patentinhaber: OCG Microelectronic Materials Inc., West Paterson New Jersey 07424 (US)
(72) Erfinder: Schädeli, Ulrich, Dr., CH-1737 Plasselb (CH); Münzel, Norbert, Dr., D-79423 Heitersheim (DE)
(74) Vertreter: Klunker . Schmitt-Nilson . Hirsch

(56) Entgegenhaltungen:
- EP-A- 0 410 794
- EP-A- 0 568 496

## Beschreibung

Die vorliegende Erfindung betrifft Polymere auf Basis von Styrol- und Maleinimidderivaten, strahlungsempfindliche Zusammensetzungen enthaltend diese Polymere, die Verwendung solcher Zusammensetzungen als Positiv-Photoresist sowie die aus diesen Zusammensetzungen hergestellten Schutzschichten und Reliefstrukturen.

Lithographie im tiefen UV-Bereich (DUV, Wellenlängen von ca. 200-300 nm) ist besonders zur Herstellung von Reliefstrukturen im Submikron-Bereich geeignet.

In der EP-A 410 794 werden Negativ-DUV-Photoresists beschrieben, die spezifische säurehärtbare Co- und Terpolymere auf Basis von Styrol und Hydroxymaleinimiden enthalten. Diese Negativ-Resists können wässrig-alkalisch entwickelt werden.

Im allgemeinen sind Positiv-Photoresists jedoch besser zur Abbildung von bestimmten geometrischen Strukturen geeignet, wie z.B. isolierten Linien, äquidistanten Linien bzw. Zwischenräumen oder Kontaktlöchern, und werden für solche Anwendungen vergleichbaren Negativ-Resists in der Regel vorgezogen.

Positiv-Photoresistzusammensetzungen auf Basis von Poly[p-tert.-butoxycarbonyloxystyrol] und Onium-Salzen, die für die Lithographie im UV-Bereich geeignet sind, sind beispielsweise aus dem US-Patent 4,491,628 bekannt.
Ähnliche Resistformulierungen enthaltend Poly[p-2-tetrahydropyranyloxy]styrol werden in der EP-A 342 498 beschrieben.
Allerdings zeigen diese chemisch verstärkten Positiv-Photoresists in Abhängigkeit von der sogenannten "delay time" Strukturveränderungen, die sich in mehr oder weniger ausgeprägten T-förmigen Profilen ("T-topping") der entwickelten Strukturen äussern. Als "delay time" bezeichnet man die Zeitdifferenz zwischen Belichtung und der nachfolgenden Wärmebehandlung ("post exposure bake"), die in der Regel erforderlich ist, um eine vollständige Reaktion der säureempfindlichen Gruppen mit der durch die Belichtung erzeugten Säure zu gewährleisten.
Für diese delay time-Effekte sind wahrscheinlich Spuren von organischen Basen in der Umgebungsatmosphäre verantwortlich. D.J.H. Funhoff, H. Binder und R. Schwalm diskutieren in "Deep-UV Resists with improved delay capacities", SPIE Vol. 1672 (Adv. Resist Technol. Process.), 46-55 (1992) verschiedene Massnahmen zur Unterdrückung dieses unerwünschten Effekts, wie beispielsweise das Aufbringen einer zusätzlichen Schutzbeschichtung, eine aufwendige Filterung der Luft, oder die Verwendung von speziellen Entwicklern zur Entfernung der "T-tops", und empfehlen schliesslich die Verwendung von spezifischen Additiven. Die auf diese Weise erzielte Stabilität gegenüber delay time-Effekten ist jedoch mit einem gewissen Empfindlichkeitsverlust verbunden.

Es wurde nun gefunden, dass bei Verwendung von spezifischen Polymeren auf Basis von Styrol- und Maleinimidderivaten als Photoresistmaterialien die oben beschriebenen delay-time-Effekte ohne Zugabe von Additiven oder Einschaltung von zusätzlichen Prozessschritten weitgehend unterdrückt werden.

Gegenstand der vorliegenden Erfindung sind Polymere mit einem Molekulargewicht (Gewichtsmittel) M_{w} von 10³ bis 10⁶ enthaltend wiederkehrende Struktureinheiten der Formeln (I), (IIa) und (IIb) 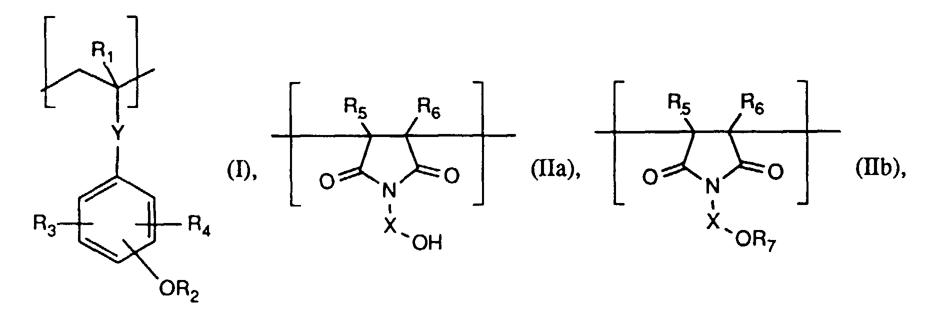 worin R₁ Wasserstoff oder Methyl bedeutet, Y für eine direkte Bindung oder einen zweiwertigen Rest der Formel (III) steht, 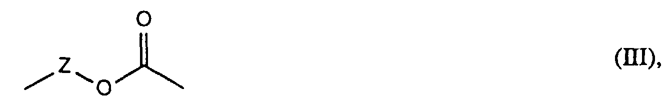 worin Z eine an den Phenylkern gebundene C₁-C₆-Alkylengruppe bedeutet,
OR₂ einen säurespaltbaren Rest darstellt,
worin R₂ C₄-C₁₀-tert.-Alkyl, unsubstituiertes oder durch eine oder mehrere C₁-C₆-Alkylgruppen, C₁-C₆-Alkoxygruppen oder Halogenatome substituiertes Allyl, Cyclohex-2-enyl, C₆-C₁₄-Aryl oder C₇-C₁₆-Aralkyl, Trialkylsilyl,
oder eine Gruppe der Formeln (IV)-(VII) darstellt 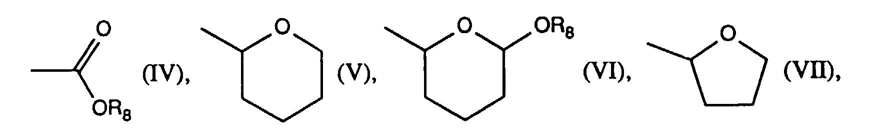 worin R₈ C₁-C₆-Alkyl oder unsubstituiertes oder durch eine oder mehrere C₁-C₆-Alkylgruppen, C₁-C₆-Alkoxygruppen oder Halogenatome substituiertes C₆-C₁₄-Aryl oder C₇-C₁₆-Aralkyl bedeutet,
R₃ und R₄ unabhängig voneinander für Wasserstoff, C₁-C₆-Alkylgruppen, C₁-C₆-Alkoxygruppen oder Halogenatome stehen,
R₅ und R₆ unabhängig voneinander Wasserstoff oder Methyl bedeuten,
X für C₁-C₆-Alkylen und R₇ für C₁-C₆-Alkyl, unsubstituiertes oder durch eine oder mehrere C₁-C₆-Alkylgruppen, C₁-C₆-Alkoxygruppen oder Halogenatome substituiertes C₆-C₁₄-Aryl oder C₇-C₁₆-Aralkyl oder für -CO-R₈ steht, worin R₈ die gleiche Bedeutung wie in Formel (IV) hat.

R₁ steht vorzugsweise für Wasserstoff.

Y stellt bevorzugt eine direkte Bindung dar.

Durch R₂, R₃, R₄, R₇ oder R₈ dargestellte Alkyl- oder Alkoxygruppen oder Alkyl- oder Alkoxygruppen als Substituenten von Allyl-, Cyclohex-2-enyl-, Aryl- oder Aralkylgruppen können geradkettig oder verzweigt sein. Als Beispiele seien genannt: Methyl, Ethyl, n-Propyl, i-Propyl, n-Butyl, sec.-Butyl, tert.-Butyl, n-Pentyl, neo-Pentyl, n-Hexyl, Methoxy, Ethoxy, n-Propoxy, i-Propoxy, n-Butoxy, sec.-Butoxy, tert.-Butoxy, n-Pentoxy, neo-Pentoxy und n-Hexoxy.

Halogenatome als Reste R₃ oder R₄ oder als Substituenten von Allyl-, Cyclohex-2-enyl-, Aryl- oder Aralkylgruppen sind vorzugsweise Brom- oder Chloratome.

Durch R₂, R₇ oder R₈ dargestellte gegebenenfalls substituierte Aryl- oder Aralkylgruppen sind beispielsweise Phenyl, Tolyl, Xylyl, Mesityl, Isityl, Naphthyl, Anthryl, Phenanthryl, Fluorenyl, Biphenyl, Benzyl, 2-Phenylethyl, 2-Phenylprop-2-yl oder Tolylmethyl.

Steht R₂ für unsubstituiertes oder substituiertes Allyl, so handelt es sich vorzugsweise um Allyl, Methallyl oder insbesondere 3-Methylbut-2-enyl.

Durch Y oder X dargestellte C₁-C₆-Alkylengruppen können ebenfalls geradkettig oder verzweigt sein. Beispiele dafür sind Methylen, Ethylen, Propylen, 2,2-Propandiyl, Trimethylen, Tetramethylen und Hexamethylen.

Bevorzugte erfindungsgemässe Polymere enthalten wiederkehrende Strukturelemente der Formel (I), worin R₁, R₃ und R₄ Wasserstoff bedeuten, Y eine direkte Bindung darstellt und R₂ für C₄-C₁₀-tert.-Alkyl, Trimethylsilyl, unsubstituiertes oder durch eine oder mehrere C₁-C₆-Alkylgruppen substituiertes Allyl, Cylohex-2-enyl oder eine Gruppe der Formeln (IV)-(VII) steht, worin R₈ C₁-C₄-Alkyl oder Phenyl bedeutet.

Besonders bevorzugt sind Polymere enthaltend wiederkehrende Strukturelemente der Formel (I), worin R₁, R₃ und R₄ Wasserstoff bedeuten, Y eine direkte Bindung darstellt und R₂ für tert.-Butyl, tert.-Butoxycarbonyl, 3-Methylbut-2-enyl oder die Gruppe der Formel (V) steht.

In den Strukturelementen der Formel (IIa) bedeuten R₅ und R₆ vorzugsweise Wasserstoff, und X steht bevorzugt für Methylen.

Bevorzugt sind weiterhin Polymere enthaltend wiederkehrende Strukturelemente der Formel (IIb), worin R₅ und R₆ Wasserstoff bedeuten, R₇ für C₁-C₄-Alkyl, Phenyl oder -CO-R₈ steht, worin R₈ C₁-C₄-Alkyl oder Phenyl ist, und X Methylen, Ethylen, Trimethylen oder Tetramethylen bedeutet.

Besonders bevorzugt sind Polymere enthaltend wiederkehrende Strukturelemente der Formel (IIb), worin R₅ und R₆ Wasserstoff bedeuten, R₇ für Methyl oder Acetyl steht und X Methylen oder Ethylen ist.

Die erfindungsgemässen Polymere enthalten vorzugsweise 10-75 mol-%, insbesondere 20-50 mol-%, Struktureinheiten der Formel (IIa) und 25-90 mol-%, insbesondere 50-80 mol-%, Struktureinheiten der Formel (IIb), bezogen auf 100 mol-% Struktureinheiten der Formel (I).

Das Molekulargewicht (Gewichtsmittel) dieser Polymeren beträgt vorzugsweise 5000-500000, insbesondere 20000-250000.

Die erfindungsgemässen Polymeren können auf bekannte Weise durch radikalische Polymerisation von Verbindungen der Formeln (IX), (Xa) und (Xb) 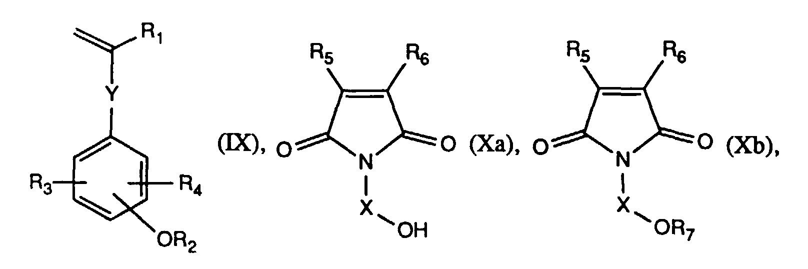 worin R₁ bis R₈, Y und X die oben angegebene Bedeutung haben, hergestellt werden.

Die radikalische Copolymerisation kann unter Anwendung verschiedener Techniken durchgeführt werden. Diese sind beispielsweise von S. Sandler und W. Karo in "Polymer Synthesis", Vol. 1, S. 3-17, 1968, Academic Press, New York, beschrieben worden. Uebliche Polymerisationsverfahren sind beispielsweise die Polymerisation in der Masse oder in Lösungsmitteln, ferner die Emulsions-, Suspension- oder Fällungspolymerisation. Das Molekulargewicht kann gegebenenfalls durch Zugabe kleiner Mengen eines Reglers (z.B. Dodecylmercaptan) eingestellt werden.

Die Ausgangsprodukte der Formeln (IX), (Xa) und (Xb) sind bekannt oder können nach bekannten Methoden hergestellt werden.

Die Verbindungen der Formel (IX), worin Y eine direkte Bindung ist und R₂ C₁-C₆-Alkyl, C₁-C₆-Alkoxy, C₆-C₁₄-Aryl, C₇-C₁₅-Aralkyl, Trimethylsilyl oder C₂-C₈-Alkenyl bedeutet, können z.B. durch Kondensation von gegebenenfalls substituiertem p-Hydroxystyrol oder α-Methyl-p-hydroxystyrol mit den entsprechenden Alkyl-, Alkoxy-, Aryl-, Aralkyl-, Trimethylsilyl- oder Alkenylhalogeniden oder -tosylaten in Gegenwart von Basen erhalten werden.

In analoger Weise sind Verbindungen der Formel (IX), worin Y eine direkte Bindung ist und R₂ für eine Gruppe der Formel ((IV) steht, aus gegebenenfalls substituiertem p-Hydroxystyrol oder α-Methyl-p-hydroxystyrol und den entsprechenden Chlorkohlensäureestern zugänglich.

Die Verbindungen der Formel (IX), worin Y eine direkte Bindung ist und R₂ für eine Gruppe der Formeln (V)-(VII) steht, können beispielsweise aus gegebenenfalls substituiertem p-Hydroxystyrol oder α-Methyl-p-hydroxystyrol durch Reaktion mit 2,3-Dihydropyran, 5-Alkoxy-, 5-Aryloxy- oder 5-Aralkoxy-2,3-dihydropyran oder 2,3-Dihydrofuran in saurer Lösung synthetisiert werden.

Die Verbindungen der Formel (IX), worin Y für einen zweiwertigen Rest der Formel (III) steht, können in analoger Weise aus den entsprechenden Acrylaten oder Methacrylaten hergestellt werden.

Beispiele für geeignete Verbindungen der Formel (IX) sind 4-Tert.-butoxystyrol, 4-Phenoxystyrol, 4-Benzyloxystyrol, 4-Trimethylsilyloxystyrol, 4-Allyloxystyrol, 4-Methallyloxystyrol, 4-(Tert.-butoxycarbonyloxy)styrol, 4-(2-Tetrahydropyranyloxy)styrol, 4-(2-Tetrahydrofuranyloxy)styrol, 4-(3-Methylbut-2-enyloxy)styrol, Methacrylsäure-4-(2-Tetrahydropyranyloxy)benzylester und Acrylsäure-4-(2-Tetrahydropyranyloxy)benzylester.

Die Verbindungen der Formel (Xa) und (Xb) sind ebenfalls bekannt oder können nach bekannten Verfahren aus Maleinimid bzw. Methyl- oder Dimethylmaleinimid hergestellt werden, beispielsweise indem Maleinimid mit einem Halogenid oder einem Tosylat der Formel LG-X-OH bzw. LG-X-OR₇, worin X und R₇ die oben angegebene Bedeutung haben und LG für Halogen oder CH₃-C₆H₄-SO₃ steht, in Gegenwart von Basen umgesetzt wird.

Die Synthese von N-Hydroxymethylmaleinimid aus Maleinimid und Formaldehyd in Gegenwart von NaOH ist beispielsweise in der EP-A 410 794 beschrieben.

Geeignete Verbindungen der Formeln (Xa) und (Xb) sind beispielweise N-Hydroxymethylmaleinimid, N-2-Hydroxyethylmaleinimid, N-3-Hydroxypropylmaleinimid, N-4-Hydroxybutylmaleinimid, N-(2-Hydroxyprop-2-yl)maleinimid, N-Methoxymethylmaleinimid, N-Phenoxymethylmaleinimid, N-Benzyloxymethylmaleinimid, N-2-Methoxyethylmaleinimid, N-3-Methoxypropylmaleinimid, N-4-Methoxybutylmaleinimid, N-Acetoxymethylmaleinimid und N-(2-Acetoxyethyl)maleinimid.

Die Polymerisation wird in der Regel durch einen üblichen Radikalstarter initiert. Dazu zählen thermische Initiatoren, wie Azoverbindungen, beispielsweise α,α'-Azoisobutyronitril (AIBN), oder Peroxide, beispielsweise Benzoylperoxid, oder Redoxinitiatorsysteme, wie eine Mischung von Eisen(III)acetyl-acetonat, Benzoin und Benzoylperoxid, oder photochemische Radikalbildner, wie Benzoin oder Benzildimethylketal.

Die Polymerisation wird bevorzugt in Lösung durchgeführt. Die Reaktionstemperatur bewegt sich im allgemeinen im Bereich von 10 bis 200°C, vorzugsweise zwischen 40 und 150°C, besonders bevorzugt zwischen 40 und 100°C.

Gegebenenfalls anwesende Lösungsmittel müssen unter den Reaktionsbedingungen inert sein. Als Lösungsmittel kommen u.a. aromatische Kohlenwasserstoffe, chlorierte Kohlenwasserstoffe, Ketone und Ether in Betracht. Beispiele hierfür sind: Benzol, Toluol, Xylole, Ethylbenzol, Isopropylbenzol, Ethylenchlorid, Propylenchlorid, Methylenchlorid, Chloroform, Methylethylketon, Aceton, Cyclohexanon, Diethylether oder Tetrahydrofuran.

Wie eingangs erwähnt, eignen sich die erfindungsgemässen Polymeren sehr gut als Basisharze für DUV-Positiv-Photoresists, die stark reduzierte Delay-Time-Effekte zeigen und ein hohes Auflösungsvermögen und eine hohe thermische Stabilität aufweisen.

Die Erfindung betrifft somit auch strahlungsempfindliche Zusammensetzungen enthaltend
a) mindestens ein erfindungsgemässes Polymer wie oben definiert und
b) mindestens eine unter der Einwirkung von aktinischer Strahlung säurebildende Verbindung.

Vorzugsweise enthalten die erfindungsgemässen Zusammensetzungen als weitere Komponente c) ein Lösungsmittel oder ein Lösungsmittelgemisch.

Weiterhin können die erfindungsgemässen Zusammensetzungen Lösungsinhibitoren enthalten, die die Löslichkeit der Zusammensetzung in üblichen alkalischen Entwicklern herabsetzen, die aber unter der Einwirkung von Säure in der Weise gespalten werden, dass die verbleibenden Reaktionsprodukte im Entwickler löslich sind. Solche Lösungsinhibitoren sind dem Fachmann bekannt und beispielsweise in der EP-A 329 610 und der EP-A 475 903 beschrieben.

Als Verbindungen b), die unter der Einwirkung von aktinischer Strahlung Säure bilden, kommen insbesondere Oniumsalze, wie Diazonium-, Sulfonium-, Sulfoxonium- und Iodoniumsalze sowie Disulfone in Betracht. Bevorzugt sind Sulfoniumsalze der Formel VIII

(Ar₁)_{q}(Z₁)ᵣ(Z₂)ₛS^{⊕}X₁^{⊖} (VIII),

worin
Ar₁ unsubstituiertes oder durch Halogen, C₁-C₄-Alkyl, C₁-C₄-Alkoxy, -OH und/oder nitro-substituiertes Phenyl, Naphthyl oder Phenyl-COCH₂- ist,
Z₁ C₁-C₆-Alkyl oder C₃-C₇-Cycloalkyl und
Z₂ Tetrahydrothienyl, Tetrahydrofuryl oder Hexahydropyryl sind,
q für 0, 1, 2 oder 3,
r für 0, 1 oder 2 und
s für 0 oder 1 stehen, wobei die Summe q+r+s 3 beträgt, und
X₁^{⊖} ein Chlorid-, Bromid- oder Iodidanion, BF₄^{⊖}, PF₆^{⊖}, AsF₆^{⊖}, SbF₆^{⊖}, FSO^{⊖} oder das Anion einer organischen Sulfonsäure oder Carbonsäure ist.

Phenyl-, Naphthyl- und Phenacylgruppen Ar₁ sind bevorzugt einfach substituiert, insbesondere durch Cl, Br, Methyl, Methoxy, -OH oder Nitro. Besonders bevorzugt sind diese Reste unsubstituiert. Z₁ ist vorzugsweise C₁-C₄-Alkyl, insbesondere Methyl oder Ethyl. Bevorzugt sind q 2 oder 3, r 1 oder Null und s Null, insbesondere ist q = 3 und r und s sind Null. Ganz besonders bevorzugt ist Ar₁ unsubstituiertes Phenyl und q ist 3.

Stellt X₁^{⊖} das Anion einer organischen Sulfonsäure oder Carbonsäure dar, so kann es sich um Anionen von aliphatischen, cycloaliphatischen, carbocyclisch-aromatischen, heterocyclisch-aromatischen oder araliphatischen Sulfon- oder Carbonsäuren handeln. Diese Anionen können substituiert oder unsubstituiert sein. Bevorzugt sind Sulfon- und Carbonsäure mit geringer Nucleophilie, beispielsweise teil- oder perfluorierte Derivate oder in Nachbarstellung zur jeweiligen Säuregruppe substituierte Derivate. Beispiele für Substituenten sind Halogen, wie Chlor oder besonder Fluor, Alkyl, wie Methyl, Ethyl oder n-Propyl, oder Alkoxy, wie Methoxy, Ethoxy oder n-Propoxy.

Beispiele für aliphatische Sulfonsäuren sind Methan-, Ethan-, n-Propan-, n-Butan- und n-Hexansulfonsäure oder die entsprechenden teil- oder perfluorierten Derivate.

Beispiele für aliphatische Carbonsäuren sind Ameisensäure, Essigsäure, Propionsäure, Buttersäure, Pivalinsäure, Capronsäure, 2-Ethylhexylcarbonsäure und Fettsäuren, wie Laurinsäure, Myristinsäure oder Stearinsäure, sowie die teil- oder perfluorierten Derivate dieser Säuren.

Beispiele für cycloaliphatische Sulfon- oder Carbonsäuren sind Cyclohexansulfonsäure, Cyclohexancarbonsäure, Campher-10-sulfonsäure oder deren teil- oder perfluorierte Derivate.

Beispiele für carbocyclisch-aromatische Sulfonsäuren sind Benzol-, Toluol-, Ethylbenzol-, Isopropylbenzol-, Dodecylbenzol- oder Dimethylbenzolsulfonsäure, 2,4,6-Triisopropylbenzolsulfonsäure, 2,4,6-Trimethylbenzolsulfonsäure, Naphthalin-mono-, -di- oder -tri-sulfonsäuren und die entsprechenden alkylierten oder teil- oder perfluorierten Derivate dieser Sulfonsäuren.

Beispiele für heterocyclisch-aromatische Sulfonsäuren sind Pyridin-, Thiophen- oder Pyrrolsulfonsäure und die entsprechenden teil- oder perfluorierten Derivate dieser Säuren.

Beispiele für araliphatische Sulfonsäuren sind Benzylsulfonsäure, α-Methylbenzylsulfonsäure und die entsprechenden teil- oder perfluorierten Derivate dieser Verbindungen.

Beispiele für carbocyclisch-aromatische Carbonsäuren sind Benzoesäure, Toluol-, Ethylbenzol-, Isopropylbenzol- oder Dimethylbenzolcarbonsäure, Naphthalincarbonsäure oder Anthracencarbonsäure und die entsprechenden teil- oder perfluorierten Derivate dieser Verbindungen.

Beispiele für heterocyclisch-aromatische Carbonsäuren sind Pyridin-, Thiophen- oder Pyrrolcarbonsäure sowie die entsprechenden teil- oder perfluorierten Derivate dieser Verbindungen.

Beispiele für araliphatische Carbonsäuren sind Benzylcarbonsäure, α-Methylbenzylcarbonsäure und Zimtsäure, sowie die entsprechenden teil- oder perfluorierten Derivate dieser Verbindungen.

Vorzugsweise handelt es sich bei X₁^{⊖} um das einwertige Anion einer organischen Sulfonsäure, insbesondere einer Teilfluor- oder Perfluorsulfonsäure. Diese Anionen zeichnen sich durch eine besonders geringe Nucleophilie aus.

Spezielle Beispiele für geeignete Sulfoniumsalze der Formel VIII sind Triphenylsulfoniumbromid, Triphenylsulfoniumchlorid, Triphenylsulfoniumiodid, Triphenylsulfoniumhexafluorphosphat, Triphenylsulfoniumhexafluorantimonat, Triphenylsulfoniumhexafluorarsenat, Triphenylsulfoniumtrifluormethansulfonat, Diphenylethylsulfoniumchlorid, Phenacyldimethylsulfoniumchlorid, Phenacyltetrahydrothiopheniumchlorid, 4-Nitrophenacyltetrahydrothiopheniumchlorid und 4-Hydroxy-2-methylphenylhexahydrothiopyryliumchlorid. Besonders bevorzugt ist Triphenylsulfoniumtrifluormethansulfonat.

Als Verbindungen b) können auch Iodoniumsalze der Formel (XI)

[Ar₂-I^{⊕}-Ar₃]X₂^{^{⊖}} (XI)

verwendet werden, worin
Ar₂ und Ar₃ unabhängig voneinander unsubstituiertes oder durch C₁-C₄-Alkyl,
C₁-C₄-Alkoxy, Halogen und/oder nitro-substituiertes Phenyl oder Naphthyl sind oder Ar₂ und Ar₃ zusammen eine Gruppe der Formel (XII) 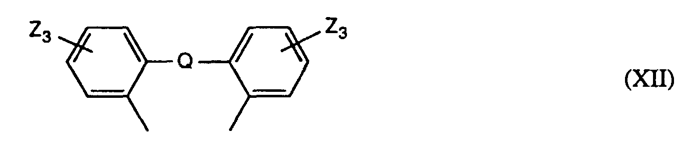 darstellen, worin Z₃ C₁-C₄-Alkyl, C₁-C₄-Alkoxy, Halogen oder Nitro und Q eine Direktbindung, -O-, -CH₂- oder -CO- darstellen und
X₂^{⊖} die gleiche Bedeutung wie X₁^{⊖} in der Formel (VIII) hat.
Iodoniumsalze der Formel (XI) sind z.B. in der GB-A 1 539 192 beschrieben.

Als Verbindungen b) eignen sich auch unter Einwirkung von aktinischer Strahlung Sulfonsäure erzeugende Substanzen der Formeln (XIII) bis (XXII) 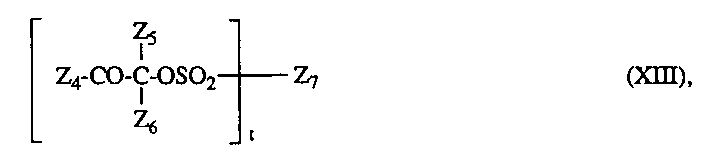 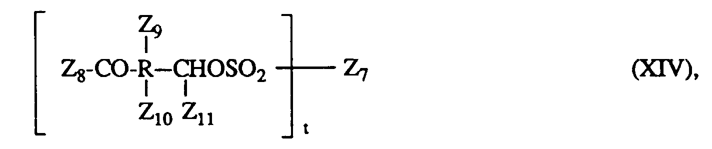 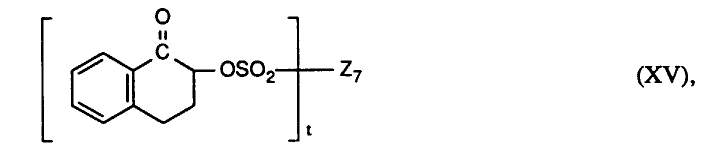 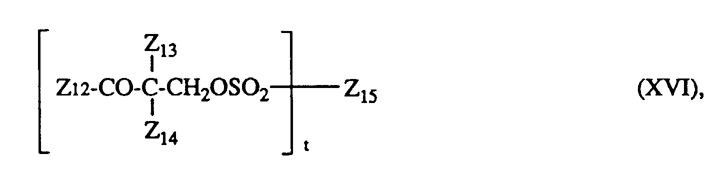 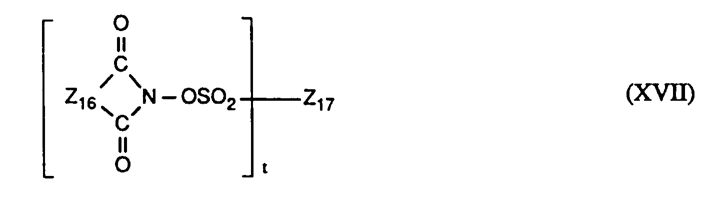 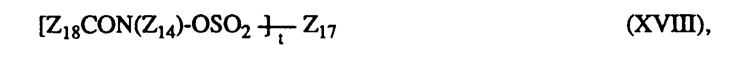 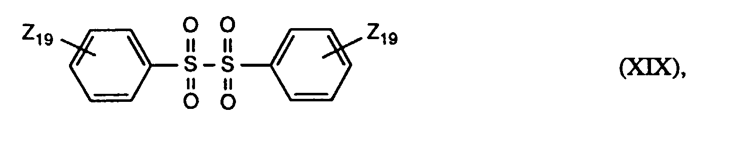 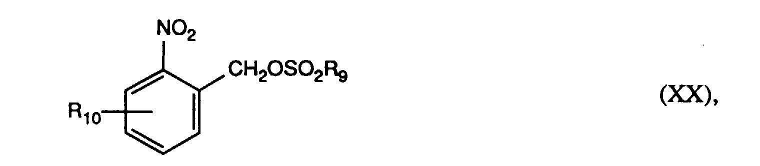 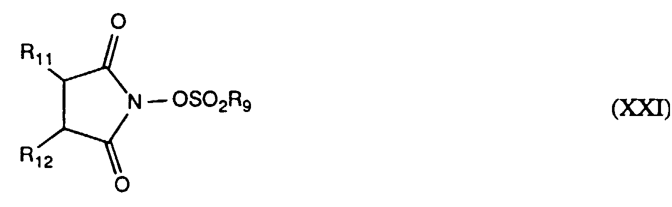 und 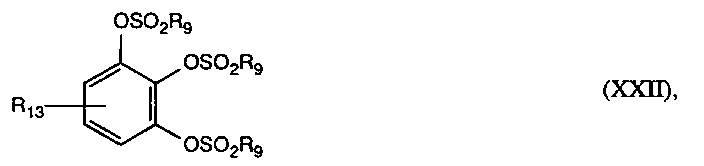 worin
t 1 oder 2, bevorzugt 1 ist,
Z₄ unsubstituiertes oder durch 1-3 -Cl, -Br, -CN, -NO₂, C₁-C₄-Alkyl, C₁-C₄-Alkoxy,
C₁-C₄-Alkylthio, Phenoxy, Phenylthio, C₁-C₄-Alkylamino, C₂-C₄-Dialkylamino oder benzoylsubstituiertes Phenyl oder Naphthyl, besonders unsubstituiertes oder einfach durch -Cl, Methyl oder Methoxy substituiertes Phenyl darstellt,
Z₅ Wasserstoff oder C₁-C₄-Alkyl und
Z₆ Wasserstoff, C₁-C₄-Alkyl oder Phenyl bedeuten oder
Z₅ und Z₆ zusammen mit dem Bindungs-C-Atom einen Cyclopentan- oder Cyclohexanring bilden,
Z₇, bei t = 1, C₁-C₁₈-Alkyl, unsubstituiertes oder durch C₁-C₄-Alkyl substituiertes Phenyl oder Naphthyl, Cyclopentyl, Cyclohexyl oder Campheryl und bei t = 2 C₂-C₈-Alkylen oder Phenylen bedeutet,
Z₈ unsubstituiertes oder durch 1-3 -Cl, -Br, C₁-C₄-Alkyl, C₁-C₄-Alkoxy, C₁-C₄-Alkylthio, Phenyl, Phenoxy, Phenylthio, C₁-C₄-Alkyl-CONH-, Benzoylamino, Dimethylamino substituiertes Phenyl oder Naphthyl, besonders unsubstituiertes oder einfach durch -Cl, C₁-C₄-Alkoxy, Methylthio oder Phenyl substituiertes Phenyl ist,
Z₉ -OH oder C₁-C₄-Alkyl ist,
Z₁₀ C₁-C₄-Alkyl oder Phenyl ist,
Z₁₁ Wasserstoff, C₁-C₄-Alkyl, Furyl oder -CCl₃ bedeutet oder
Z₁₀ und Z₁₁ zusammen mit dem Bindungs-C-Atom einen Cyclopentan- oder Cyclohexanring bilden,
Z₁₂ und Z₁₃ unabhängig voneinander unsubstituiertes oder durch Halogen, C₁-C₄-Alkyl oder C₁-C₄-Alkoxy substituiertes Phenyl sind,
Z₁₄ Wasserstoff oder C₁-C₄-Alkyl darstellt,
Z₁₅ bei t = 1, C₁-C₆-Alkyl, Phenyl, Naphthyl oder Benzyl und bei t = 2 C₁-C₆-Alkylen, Phenylen oder Xylylen darstellt,
Z₁₆ unsubstituiertes oder durch Halogen, Nitro, C₁-C₄-Alkyl, C₁-C₄-Alkoxy oder C₁-C₄-Alkylthio substituiertes Phenylen oder Naphthylen oder -CH=CH- ist,
Z₁₇ bei t = 1 unsubstituiertes oder durch Halogen, Nitro, C₁-C₄-Alkyl oder C₁-C₄-Alkoxy substituiertes C₁-C₁₂-Alkyl oder unsubstituiertes oder durch Halogen, Nitro, C₁-C₄-Alkyl oder C₁-C₄-Alkoxy substituiertes Phenyl und bei t = 2 C₂-C₈-Alkylen oder Phenylen ist,
Z₁₈ unsubstituiertes oder durch Halogen, Nitro, -CN, C₁-C₄-Alkyl, Methoxy, Ethoxy, Dimethylamino oder Benzoyl substituiertes Phenyl oder Naphthyl bedeutet und die Z₁₉ unabhängig voneinander C₁-C₄-Alkyl sind,
R₉ unsubstituiertes oder durch Halogen, Nitro, C₁-C₄-Alkyl oder C₁-C₄-Alkoxy substituiertes C₁-C₁₂-Alkyl oder unsubstituiertes oder durch Halogen, Nitro, C₁-C₄-Alkyl oder C₁-C₄-Alkoxy substituiertes Phenyl ist,
R₁₀ für C₁-C₄-Alkyl, C₁-C₄-Alkoxy oder Phenyl steht,
R₁₁ und R₁₂ unabhängig voneinander für C₁-C₄-Alkyl, C₁-C₄-Alkoxy oder Phenyl stehen oder zusammen einen Rest der Formeln (XXIII), (XXIV) oder (XXV) bedeuten 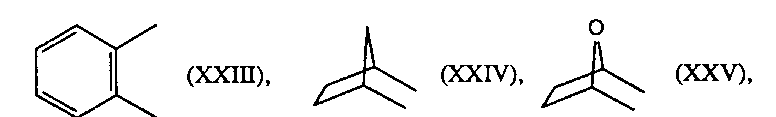
und R₁₃ C₁-C₄-Alkyl, C₁-C₄-Alkoxy, Phenyl oder Benzoyl darstellt.
Definitionsgemässe Alkyl-, Alkoxy-, Alkylthio-, Alkylamino-, Dialkylamino-, Alkylcarbamoyl- und Alkylengruppen können geradketting oder verzweigt sein, sind aber bevorzugt geradkettig. Halogen bedeutet insbesondere -Cl oder -Br.

Verbindungen der Formeln (XIII) bis (XXII) sind z.B. in den EP-A 0 166 682 und 0 085 024 sowie der darin zitierten Literatur beschrieben. Besonders bevorzugte Verbindungen der Formeln (XIII) bis (XXII) sind Phenacyl-p-methylbenzolsulfonat, Benzoin-p-toluolsulfonat, α-(p-Toluolsulfonyloxy)methylbenzoin-3-(p-Toluolsulfonyloxy)-2-hydroxy-2-phenyl-1-phenylpropylether, N-(p-Dodecylbenzolsulfonyloxy)-1,8-naphthalimid und N-(Phenylsulfonyloxy)-1,8-naphthalimid.

Weitere geeignete Verbindungen b) sind o-Nitrobenzaldehyde, die sich unter aktinischer Bestrahlung in o-Nitrosobenzoesäuren umlagern, wie 1-Nitrobenzaldehyd und 2,6-Dinitrobenzaldehyd; α-Halogenacylphenone, wie α,α,α-Trichloracetophenon und p-tert.Butyl-α,α,α-trichloracetophenon, sowie Sulfonsäureester von o-Hydroxyacylphenonen, wie 2-Hydroxybenzophenonmethansulfonat und 2,4-Hydroxybenzophenon-bis-(methansulfonat).

Schliesslich eignen sich als Verbindungen b) auch solche, die aromatisch gebundenes Chlor oder Brom enthalten, wie sie beispielsweise in der EP-A 0 318 649 beschrieben sind, z.B. Verbindungen der Formel (XXVI) 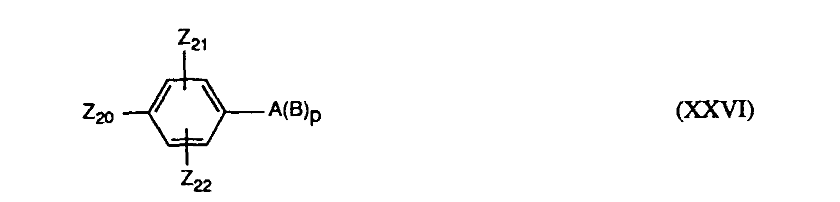 mit mindestens einem aromatisch gebundenen Chlor- oder Bromatom, worin z.B. p 0 oder 1 bedeutet,
Z₂₀ -COOH, -OZ₂₃ oder -SZ₂₃ ist,
Z₂₁ und Z₂₂ unabhängig voneinander Wasserstoff, -Cl, -Br, gegebenenfalls durch Aryl, Alkoxy, Aryloxy, -OH oder -F substituiertes Alkyl oder gegebenenfalls durch Alkoxy, Aryloxy, -OH oder Halogen substituiertes Aryl sind,
Z₂₃ Wasserstoff, gegebenenfalls analog Z₂₁ substituiertes Alkyl oder Aryl oder Acyl ist, A bei p =0, Wasserstoff, -Cl, -Br, gegebenenfalls analog zu Z₂₁ substituiertes Alkyl und bei p = 1, -SO₂-, Propylen oder Peffluoralkylen ist und B eine Gruppe 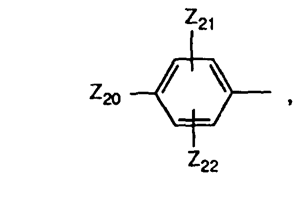 Alkylcarbonyl, Alkoxycarbonyl oder substituiertes Sulfonylimidocarbonyl bedeutet.
Beispiele derartiger Verbindungen sind Hexafluortetrabrom-Bisphenol A, 1,1,1-Tris-(3,5-dibrom-4-hydroxyphenyl)ethan und N-(2,4,6-Tribromphenyl)-N'-(p-toluolsulfonyl)harnstoff.

Besonders bevorzugt verwendet man als Verbindungen b) solche der Formel (VIII), worin Ar₁ Phenyl bedeutet, q die Zahl 3 ist, r und s Null sind, und X₁^{⊖} SbF₆^{⊖}, AsF₆^{⊖}, PF₆^{⊖}, CF₃SO₃^{⊖}, C₂F₅SO₃^{⊖}, n-C₃F₇SO₃^{⊖}, n-C₄F₉SO₃^{⊖}, n-C₆F₁₃SO₃^{⊖}, n-C₈F₁₇SO₃^{⊖} oder C₆F₅SO₃^{⊖} darstellt.

Ganz besonders bevorzugt verwendet man als Komponente b) Triphenylsulfoniumtrifluormethansulfonat.

Die Verbindungen b) werden zweckmässig in einer Menge von 0,1-20 Gew.-%, vorzugsweise 1-10 Gew.-% und insbesondere 1-6 Gew.-%, bezogen auf das Gewicht der Komponente a), eingesetzt

Die erfindungsgemässen Zusammensetzungen können weitere übliche Zusatzstoffe enthalten, wie z.B. Bindemittel, Stabilisatoren, Pigmente, Farbstoffe, Füllstoffe, Haftvermittler, Verlaufmittel, Netzmittel und Weichmacher. Bevorzugt sind die Zusammensetzungen zur Applikation in geeigneten Lösungsmitteln [Komponente c)] gelöst.

Die Wahl des Bindemittels erfolgt je nach dem Anwendungsgebiet und den hierfür geforderten Eigenschaften. Geeignete Bindemittel sind beispielsweise Novolake, die sich von einem Aldehyd, vorzugsweise Formaldehyd, Acetaldehyd oder Furfuraldehyd, besonders jedoch von Formaldehyd, und einem Phenol ableiten. Die phenolische Komponente dieser Bindemittel ist vorzugsweise Phenol selbst, oder auch halogeniertes Phenol, beispielsweise substituiert mit ein bis zwei Chloratomen, vorzugsweise p-Chlorphenol, oder sie ist ein durch ein bis zwei C₁-C₉-Alkylgruppen substituiertes Phenol, beispielsweise o-, m- oder p-Kresol, ein Xylenol, p-tert.Butylphenol oder p-Nonylphenol. Es kann sich bei der Phenolkomponente der bevorzugten Novolake aber auch um p-Phenylphenol, Resorcin, Bis-(4-hydroxyphenyl)-methan oder 2,2-Bis(4-hydroxyphenyl)-propan handeln.

Weitere geeignete Bindemittel sind beispielsweise Copolymere von Maleinsäureanhydrid mit Styrol, Vinylethern oder 1-Alkenen. Homo- oder copolymere Acrylate und Methacrylate, z.B. Copolymere aus Methylmethacrylat/Ethylacrylat/Methacrylsäure, Poly(methacrylsäurealkylester) oder Poly(acrylsäurealkylester) mit z.B. 1-20 C-Atomen im Alkylrest lassen sich ebenfalls als Bindemittel einsetzen.

Vorzugsweise verwendet man als Bindemittel eine alkalilösliche Substanz, beispielsweise einen Novolak (gegebenenfalls modifiziert wie oben beschrieben), Poly(4-hydroxystyrol) oder Poly(4-hydroxy-3,5-dimethylstyrol), Copolymere von Maleins Maleinsäureanhydrid mit Styrol, Vinylethern oder 1-Alkenen, sowie Copolymere von Acrylsäure- oder Methacrylsäureestern mit ethylenisch ungesättigten Säuren, beispielsweise Methacrylsäure oder Acrylsäure.

Die in einem Lösungsmittel oder Lösungsmittelgemisch gelösten erfindungsgemässen strahlungsempfindlichen Zusammensetzungen eignen sich hervorragend als Beschichtungsmittel für Substrate aller Art, z.B. Holz, Textilien, Papier, Keramik, Glas, Kunststoffe, wie Polyester, Polyethylenterephthalat, Polyolefine oder Celluloseacetat, insbesondere in Form von Filmen, sowie Metalle, wie Al, Cu, Ni, Fe, Zn, Mg oder Co, und GaAs, Si oder SiO₂, auf denen durch bildmässiges Belichten eine Abbildung aufgebracht werden soll.

Die Wahl des Lösungsmittels und die Konzentration richten sich hauptsächlich nach der Art der Zusammensetzung und nach dem Beschichtungsverfahren. Das Lösungsmittel soll inert sein, d.h. es soll mit den Komponenten keine chemische Reaktion eingehen und es soll bei der Trocknung nach dem Beschichten wieder enfernt werden können. Geeignete Lösungsmittel sind z.B. Ketone, Ether und Ester, wie Methylethylketon, 2-Heptanon, Cyclopentanon, Cyclohexanon, γ-Butyrolacton, Ethylpyruvat, Diethylenglykoldimethylether, 2-Methoxyethanol, 2-Ethoxyethanol, 2-Ethoxyethylacetat, 1-Methoxy-2-propylacetat, 1,2-Dimethoxyethan, Essigsäureethylester, und 3-Methoxymethylpropionat.

Die Lösung wird mittels bekannter Beschichtungsverfahren gleichförmig auf ein Substrat aufgebracht, z.B. durch Schleudern, Tauchen, Rakelbeschichtung, Vorhanggiessverfahren, Aufpinseln, Sprühen, speziell durch elektrostatisches Sprühen und Reverse-Rollbeschichtung. Es ist auch möglich, die lichtempfindliche Schicht auf einen temporären, flexiblen Träger zu bringen und dann durch Schichtübertragung via Lamination das endgültige Substrat, z.B. eine kupferkaschierte Leiterplatte, zu beschichten.

Die Auftragsmenge (Schichtdicke) und die Art des Substrats (Schichtträger) sind vom gewünschten Applikationsgebiet abhängig. Der Schichtdickenbereich umfasst im allgemeinen Werte von ca. 0,1 µm bis mehr als 10 µm.

Nach dem Beschichten wird das Lösungsmittel in der Regel durch Trocknen entfernt, und es resultiert eine Schicht der erfindungsgemässen Zusammensetzung auf dem Träger.

Die erfindungsgemässen strahlungsempfindlichen Zusammensetzungen eignen sich als Photoresists für die Elektronik (Galvanoresist, Aetzresist, Lötstopresist), für die Herstellung von Druckplatten, wie Offsetdruckplatten oder Siebdruckformen, für den Einsatz beim Formteilätzen oder den Einsatz als Mikroresist bei der Herstellung integrierter Schaltkreise. Dementsprechend unterschiedlich sind die möglichen Schichtträger und die Verarbeitungsbedingungen der beschichteten Substrate.

Die Verwendung der erfindungsgemässen Zusammensetzungen als Positiv-Photoresist bildet einen weiteren Erfindungsgegenstand.

Für photographische Informationsaufzeichnungen dienen z.B. Folien aus Polyester, Celluloseacetat oder mit Kunststoff beschichtete Papiere; für Offsetdruckformen speziell behandeltes Aluminium, für die Herstellung gedruckter Schaltungen kupferkaschierte Laminate und für die Herstellung von integrierten Schaltkreisen Siliziumwafer. Die Schichtdicken für photographische Materialien und Offsetdruckformen betragen in der Regel ca. 0,5 µm bis 10 µm, für gedruckte Schaltungen 0,4 bis ca. 2 µm.

Zur Herstellung von Reliefstrukturen wird das mit der erfindungsgemässen Zusammensetzung beschichtete Substrat bildmässig belichtet. Der Begriff 'bildmässige' Belichtung beinhaltet sowohl die Belichtung durch eine Photomaske, die ein vorbestimmtes Muster enthält, beispielsweise ein Diapositiv, die Belichtung durch einen Laserstrahl, der beispielsweise computergesteuert über die Oberfläche des beschichteten Substrates bewegt wird, und auf diese Weise ein Bild erzeugt, die Bestrahlung mit computergesteuerten Elektronenstrahlen, sowie die Bestrahlung mit Röntgen- oder UV-Strahlen durch eine entsprechende Maske.

Als Strahlungsquellen können im Prinzip sämtliche Lampen verwendet werden, die Strahlung im UV-Bereich emittieren. Es sind sowohl Punktlichtquellen als auch flächenförmige Strahler (Lampenteppiche) geeignet. Beispiele sind:
Kohlelichtbogenlampen, Xenon-Lichtbogenlampen, Quecksilberdampflampen, gegebenenfalls mit Metall-Halogeniden dotiert (Metall-Halogenlampen), Fluoreszenzlampen, Argonglühlampen, Elektronenblitzlampen, photographische Flutlichtlampen, Elektronenstrahlen und Röntgenstrahlen. Der Abstand zwischen Lampe und erfindungsgemässem Bildmaterial kann je nach Anwendungszweck und Lampentyp bzw. -stärke variieren, z.B. zwischen 2 cm bis 150 cm. Speziell geeignet sind Laserlichtquellen, z.B. Argonionenlaser oder Kryptonionenlaser. Mit Laserlicht kann der Resist auch ohne Maske belichtet werden, indem der gesteuerte Laser-Strahl direkt auf der Resist-Schicht schreibt. Hier ist die hohe Empfindlichkeit der erfindungsgemässen Materialien sehr vorteilhaft, die hohe Schreibgeschwindigkeiten bei relativ niedrigen Intensitäten erlaubt. Nach dieser Methode können gedruckte Schaltungen in der Elektronikindustrie, lithographische Offsetdruckplatten oder Reliefdruckplatten sowie photographische Bildaufzeichnungsmaterialien hergestellt werden. Die hohe Empfindlichkeit der Resists ist auch für die Belichtung mittels DUV-Stepper von Vorteil, da sehr kurze Belichtungszeiten erwünscht sind.

Nach der Belichtung wird der Resist in der Regel einer Wärmebehandlung, dem sogenannten "post exposure bake", unterzogen, um eine vollständige Reaktion der säureempfindlichen Gruppen im Polymergerüst mit der durch die Belichtung erzeugten Säure zu gewährleisten. Die Dauer und die Temperatur dieses post exposure bake können in weiten Bereichen variieren und hängen im wesentlichen von der Zusammensetzung des säureempfindlichen Polymeren und von der Art des verwendeten Säuregenerators sowie von den Konzentrationen dieser beiden Komponenten ab. Üblicherweise wird der belichtete Resist wenige Sekunden bis einige Minuten Temperaturen von etwa 50-150 °C ausgesetzt.
Überraschenderweise ist bei den erfindungsgemässen Resists die delay time, bei der noch keine T-tops auftreten, im Vergleich zu den bisher bekannten Positiv-Photoresist-Systemen, z.B. den in der EP-A 366 590 oder der EP-A 342 498 beschriebenen Positiv-Resists, wesentlich verlängert.

Nach der in üblicher Weise erfolgten bildmässigen Belichtung und Wärmebehandlung des Materials werden die belichteten Stellen des Photolackes durch Herauslösen in einem Entwickler entfernt.

Die Wahl des jeweiligen Entwicklers richtet sich nach der Art des Photolackes, insbesondere nach der Natur des verwendeten Bindemittels oder der entstehenden Photolyseprodukte. Der Entwickler kann wässrige Lösungen von Basen umfassen, denen gegebenenfalls organische Lösungsmittel oder deren Mischungen zugesetzt wurden.

Besonders bevorzugt als Entwickler werden wässrig alkalische Lösungen, wie sie auch für die Entwicklung von Naphthochinondiazidschichten eingesetzt werden. Dazu zählen insbesondere wässrige Lösungen von Alkalimetallsilikaten, -phosphaten, -hydroxiden und -carbonaten. Diesen Lösungen können gegebenenfalls noch kleinere Mengen an Netzmitteln und/oder organischen Lösungsmitteln zugesetzt sein.

Typische organische Lösungsmittel, die den Entwicklerflüssigkeiten zugesetzt werden können, sind beispielsweise Cyclohexanon, 2-Ethoxyethanol, Toluol, Aceton, Isopropanol, Ethanol, sowie Mischungen zweier oder mehrerer dieser Lösungsmittel.

Abgesehen von den stark reduzierten delay time-Effekten zeichnen sich die erfindungsgemässen Resistzusammensetzungen durch gute anwendungstechnische Eigenschaften sowie eine hohe optische Transparenz, hohe thermische Stabilität und ein sehr gutes Auflösungsvermögen (Submikronbereich) aus.

Die unter Verwendung der erfindungsgemässen Photoresistzusammensetzungen hergestellten Schutzschichten und Reliefstrukturen stellen einen weiteren Erfindungsgegenstand dar.

### Beispiele

### I. Herstellung der Polymeren

I.1. Terpolymer aus 4-(2-Tetrahydropyranyloxy)styrol, N-Hydroxymethylmaleinimid und N-Acetoxymethylmaleinimid
   In einem 100 ml-Rundkolben werden 4,1 g (20 mmol) 4-(2-Tetrahydropyranyloxy)styrol, 1,3 g (10 mmol) N-Hydroxymethylmaleinimid, 1,7 g (10 mmol) N-Acetoxymethylmaleinimid und 0,3 g Dibenzoylperoxid in 30 ml Tetrahydrofuran (THF) gelöst. Die Lösung wird 4 h bei 60 °C gerührt. Nach Abkühlen auf Raumtemperatur wird das Polymer in 1 l Methanol ausgefällt, abfiltriert und getrocknet. Es werden 6,2 g (87 %) eines weissen Pulvers erhalten, das wie folgt charakterisiert wird:
   - ¹H-NMR (CDCl₃, 300 MHz):: δ = 6,3-7,4 ppm (m)
   δ = 5,1-5,6 ppm (s, breit)
   δ = 4,7-5,0 ppm (s, breit)
   δ = 3,8-4,0 ppm (s, breit)
   δ = 3,5-3,8 ppm (s, breit)
   δ = 1,2-2,3 ppm (m)

   Mittels Gelpermeationschromatographie (GPC, Polystyrol-Eichung) wird ein Molekulargewicht von Mₙ = 13950 (Zahlenmittel) und M_{w} = 47950 (Gewichtsmittel) gemessen, woraus sich ein Polymolekularitätsindex PD = M_{w}/Mₙ von 3,4 ergibt Die thermogravimetrische Analyse (TGA, Heizrate 10 °C/min) zeigt im Temperaturbereich von 140-240 °C einen Gewichtsverlust von 32 %.
I.2-I.10. Terpolymere aus 4-(2-Tetrahydropyranyloxy)styrol, N-Hydroxymethylmaleinimid und N-Acetoxymethylmaleinimid
   Analog zu Beispiel I.1. werden Terpolymere mit unterschiedlichen Monomerverhältnissen hergestellt. Die Mengen der eingesetzten Ausgangsverbindungen sowie die Ausbeuten und die gemessenen Molekulargewichte sind in nachstehender Tabelle 1 dargestellt. 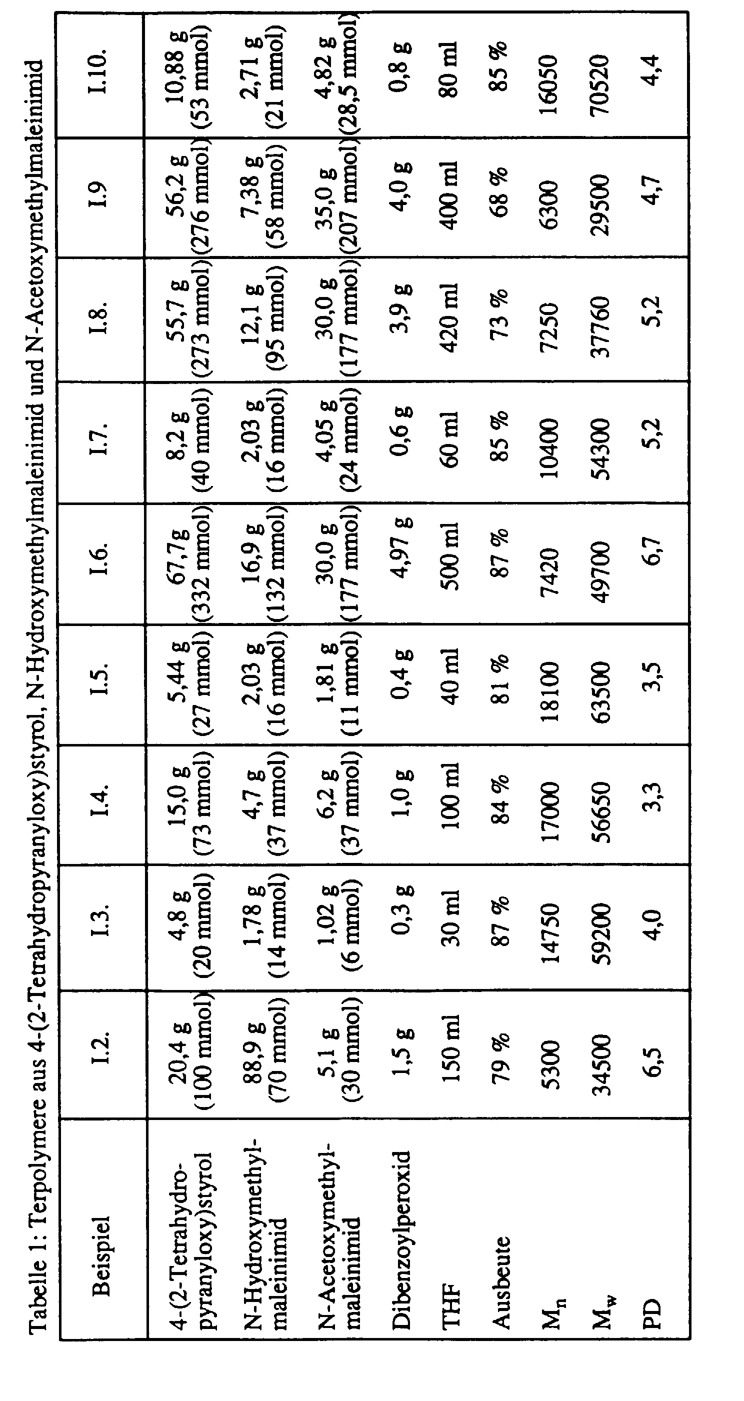
I.11. Terpolymer aus 4-(Tert-butoxycarbonyloxy)styrol, N-Hydroxymethylmaleinimid und N-Acetoxymethylmaleinimid
   In einem 150 ml-Rundkolben werden 11,0 g (54 mmol) 4-(Tert.-butoxycarbonyloxy)styrol, 1,6 g (12,5 mmol) N-Hydroxymethylmaleinimid, 6,3 g (37,5 mmol) N-Acetoxymethylmaleinimid und 0,76 g Dibenzoylperoxid in 80 ml THF gelöst. Die Lösung wird 4 h bei 60 °C gerührt. Nach Abkühlen auf Raumtemperatur wird das Polymer in 1 l Methanol ausgefällt, abfiltriert und anschliessend in 100 ml THF gelöst. Diese Lösung wird nun langsam in 1 l eines Lösungsmittelgemisches aus n-Hexan und Toluol gegeben. Der gebildete Niederschlag wird abfiltriert und getrocknet, wobei 15,2 g (80 %) eines weissen Pulvers erhalten werden.
   - ¹H-NMR (CDCl₃, 300 MHz):: δ = 6,2-7,5 ppm (m)
   δ = 5,3 ppm (s, breit)
   δ = 4,8 ppm (s, breit)
   δ = 2,4-3,5 ppm (m)
   δ = 2,0 ppm (s)
   δ = 1,5 ppm (s)
   - GPC (Polystyrol-Eichung):: Mₙ = 11950
   M_{w} = 38650
   PD = 3,2
   TGA (10 °C/min): 27 % Gewichtsverlust im Bereich von 130-180 °C.
I.12. Terpolymer aus 4-Tert.-butoxystyrol, N-Hydroxymethylmaleinimid und N-Acetoxymethylmaleinimid
   Analog zu Beispiel I.11. werden aus 8,8 g (50 mmol) 4-Tert.-butoxystyrol, 1,6 g (12,5 mmol) N-Hydroxymethylmaleinimid, 6,3 g (37,5 mmol) N-Acetoxymethylmaleinimid und 0,67 g Dibenzoylperoxid, gelöst in 80 ml THF, 13,9 g (83 %) eines weissen Pulvers erhalten.
   - ¹H-NMR (CDCl₃, 300 MHz):: δ = 6,2-7,3 ppm (m)
   δ = 5,3 ppm (s, breit)
   δ = 4,8 ppm (s, breit)
   δ = 2,4-3,6 ppm (m)
   δ = 2,0 ppm(s)
   δ = 1,3 ppm (s)
   - GPC (Polystyrol-Eichung):: Mₙ = 18980
   M_{w} = 65150
   PD = 3,4
   TGA (10 °C/min): 20 % Gewichtsverlust im Bereich von 280-340 °C.
I.13. Terpolymer aus 4-(3-Methylbut-2-enyloxy)styrol, N-Hydroxymethylmaleinimid und N-Acetoxymethylmaleinimid
   a) Synthese von 4-(3-Methylbut-2-enyloxy)styrol:
      In einem 500 ml-Dreihalskolben mit Innenthermometer, Stickstoffüberleitung und Magnetrührer werden 22 g (0,4 mol) KOH-Pulver in 200 ml Dimethylsulfoxid vorgelegt. 12,0 g (0,1 mol) p-Hydroxystyrol werden dann bei 20 °C portionsweise zugegeben; anschliessend werden 30,0 g (0,2 mol) 3,3'-Dimethylallylbromid bei 20 °C zugetropft. Nach 30 min Rühren bei 20 °C werden 100 g Eis langsam hinzugegeben. Danach wird zweimal mit je 200 ml Ether extrahiert. Die vereinigten organischen Extrakte werden zunächst mit 200 ml 1N-Natronlauge und danach mit 200 ml Wasser gewaschen und über MgSO₄ getrocknet. Nach Entfernen des Lösungsmittels wird der verbleibende Rückstand im Vakuum destilliert (0,07 mbar, 80 °C). Es werden 15,5 g (82 mmol, 82 %) eines farblosen Öls erhalten.
      - ¹H-NMR (CDCl₃, 300 MHz):: δ = 7,31 ppm (d, 2H)
      δ = 6,85 ppm (dd, 1H)
      δ = 6,63 ppm (dd, 1H)
      δ = 5,58 ppm (dd, 1H)
      δ = 5,47 ppm (t, 1H)
      δ = 5,09 ppm (dd, 1H)
      δ = 4,47 ppm (d, 2H)
      δ = 1,86 ppm (s, 3H)
      δ = 1,77 ppm (s, 3H)
   b)Synthese des Terpolymeren:
      Analog zu Beispiel I.11. werden aus 9,4 g (50 mmol) 4-(3-Methylbut-2-enyloxy)styrol, 1,6 g (12,5 mmol) N-Hydroxymethylmaleinimid, 6,3 g (37,5 mmol) N-Acetoxymethylmaleinimid und 0,69 g Dibenzoylperoxid, gelöst in 75 ml THF, 14,73 g (85 %) eines weissen Pulvers erhalten.
      - ¹H-NMR (CDCl₃, 300 MHz):: δ = 6,3-7,4 ppm (m)
      δ = 5,1-5,4 ppm (m)
      δ = 4,4 ppm (s)
      δ = 2,4-3,5 ppm (m)
      δ = 2,0 ppm (s)
      δ = 1,8 ppm (s)
      - GPC (Polystyrol-Eichung):: Mₙ = 23580
      M_{w} = 235500
      PD = 9,9
   TGA (10 °C/min): 14 % Gewichtsverlust im Bereich von 260-320 °C.
   I.14. Terpolymer aus 4-(2-Tetrahydropyranyloxy)styrol, N-Hydroxymethylmaleinimid und N-(2-Acetoxyethyl)maleinimid
      Analog zu Beispiel I.1. werden aus 4,1 g (20 mmol) 4-(2-Tetrahydropyranyloxy)styrol, 1,3 g (10 mmol) N-Hydroxymethylmaleinimid, 1,8 g (10 mmol) N-(2-Acetoxyethyl)maleinimid und 0,3 g Dibenzoylperoxid, gelöst in 30 ml THF, 5,4 g (75 %) eines weissen Pulvers erhalten.
      - ¹H-NMR (CDCl₃, 300 MHz):: δ = 6,4-7,3 ppm (m)
      δ = 5,35 ppm (s)
      δ = 4,8 ppm (s)
      δ = 3,9 ppm (m)
      δ = 3,6 ppm (m)
      δ = 1,3-3,0 ppm (m)
      - GPC (Polystyrol-Eichung):: Mₙ = 8150
      M_{w} = 59100
      PD = 7,2

      TGA (10 °C/min): 29 % Gewichtsverlust im Bereich von 180-230 °C.
   I.15. Terpolymer aus 4-(2-Tetrahydropyranyloxy)styrol, N-Hydroxymethylmaleinimid und N-(2-Methoxyethyl)maleinimid
      Analog zu Beispiel I.1. werden aus 4,1 g (20 mmol) 4-(2-Tetrahydropyranyloxy)styrol, 1,3 g (10 mmol) N-Hydroxymethylmaleinimid, 1,55 g (10 mmol) N-(2-Methoxyethyl)maleinimid und 0,3 g Dibenzoylperoxid, gelöst in 30 ml THF, 5,2 g (75 %) eines weissen Pulvers erhalten.
      - ¹H-NMR (CDCl₃, 300 MHz):: δ = 6,4-7,3 ppm (m)
      δ = 5,4 ppm (s)
      δ = 4,8 ppm (s)
      δ = 3,9 ppm (m)
      δ = 3,5 ppm (m)
      δ = 3,2 ppm (m)
      δ = 1,3-2,9 ppm (m)
      - GPC (Polystyrol-Eichung):: Mₙ = 6660
      M_{w} = 54800
      PD = 8,2
      TGA (10 °C/min): 30 % Gewichtsverlust im Bereich von 150-240 °C.
   I.16. Terpolymer aus Methacrylsäure-4-(2-Tetrahydropyranyloxy)benzylester, N-Hydroxymethylmaleinimid und N-(Acetoxymethyl)maleinimid
      Analog zu Beispiel I.1. werden aus 21,8 g (79 mmol) Methacrylsäure-4-(2-Tetrahydropyranyloxy)benzylester, 6,3 g (49 mmol) N-Hydroxymethylmaleinimid, 5,0 g (30 mmol) N-(Acetoxymethyl)maleinimid und 1,0 g Dibenzoylperoxid, gelöst in 130 ml THF, 9,3 g (28 %) eines weissen Pulvers erhalten.
      - ¹H-NMR (CDCl₃, 300 MHz):: δ = 6,7-7,4 ppm (m)
      δ = 5,4 ppm (s)
      δ = 4,9 ppm (s)
      δ = 3,8 ppm (m)
      δ = 3,6 ppm (m)
      δ = 0,8-3,0 ppm (m)
      - GPC (Polystyrol-Eichung):: Mₙ = 4270
      M_{w} = 13030
      PD =3,0
      TGA (10 °C/min): 27 % Gewichtsverlust im Bereich von 150-300 °C.
   I.17. Terpolymer aus 4-(2-Tetrahydropyranyloxy)styrol, N-Hydroxymethylmaleinimid und N-(Acetoxymethyl)maleinimid
      Analog zu Beispiel I.1. werden aus 5,1 g (25 mmol) 4-(2-Tetrahydropyranyloxy)styrol, 0,48 g (4 mmol) N-Hydroxymethylmaleinimid, 3,59 g (21 mmol) N-(Acetoxymethyl)maleinimid, 0,18 g Dodekanthiol und 0,18 g Bisazoisobutyronitril, gelöst in 64 ml Diglyme, 7,5 g (80 %) eines weissen Pulvers erhalten.
      - GPC (Polystyrol-Eichung):: Mₙ = 9700
      M_{w} = 20700
      PD = 2,1

### II. Applikationsbeispiele

### II.1. Positiv-Photoresist

2 g des Polymeren aus Beispiel I.14 und 0,1 g Triphenylsulfoniumtriflat werden in 7 g Cyclopentanon gelöst. Die Lösung wird filtriert und bei 3000 U/min auf einen Quarzwafer (3 Zoll) aufgeschleudert. Der beschichtete Quarzwafer wird anschliessend 2 min bei 120 °C getrocknet. Die Schichtdicke des so erhaltenen Films beträgt 1 µm. Der beschichtete Wafer wird nun durch eine Quarzmaske mit monochromatischer Strahlung der Wellenlänge 254 nm (10 nm Halbwertsbreite) mit einer Dosis von 30 mJ/cm² bildmässig belichtet (Kontaktbelichtung). Nach der Belichtung wird der Wafer auf einer Heizplatte 2 min einer Temperatur von 120 °C ausgesetzt und anschliessend in einer 2,38 %igen wässrigen Tetramethylammoniumhydroxidlösung entwickelt, wobei die belichteten Zonen herausgelöst werden. Strukturen von 0,5 µm mit annähernd vertikalen Wandprofilen werden ohne Ausbildung von T-topping-Effekten einwandfrei aufgelöst.

### II.2. Positiv-Photoresist

1,92 g des Polymeren aus Beispiel I.17 und 0,08 g Triphenylsulfoniumtriflat werden in 8,0 ml Methoxypropylacetat gelöst. Die Lösung wird durch einen Filter mit einer Porengrösse von 0,5 mm filtriert und anschliessend auf einen Siliziumwafer (4 Zoll) aufgeschleudert, wobei nach dem Trocknen bei 100 °C während 60 Sekunden ein Resistfilm mit einer Dicke von 850 nm resultiert. Der beschichtete Wafer wird nun mit Strahlung der Wellenlänge 248 nm mit einem Canon Excimer Laser Stepper (NA: 0,37) mit einer Dosis von 18 mJ/cm² bildmässig belichtet. Nach der Belichtung wird der Wafer auf einer Heizplatte 1 min einer Temperatur von 110 °C ausgesetzt und anschliessend in einer 0,262 N wässrigen Tetramethylammoniumhydroxidlösung entwickelt, wobei die belichteten Zonen herausgelöst werden. Dabei werden lines/spaces-Strukturen von 0,3 µm mit annähernd vertikalen Wandprofilen rückstandsfrei aufgelöst.
In einem zweiten analog durchgeführten Experiment wird nach der Belichtung eine Stunde gewartet, bis die Wärmebehandlung bei 110 °C während 1 min durchgeführt wird. Auch in diesem Fall werden lines/spaces-Strukuren von 0,3 µm sauber aufgelöst, ohne erkennbare Ausbildung von T-topping-Effekten.

### II.3. Positiv-Photoresist

1,92 g des Polymeren aus Beispiel I.11 und 0,07 g Triphenylsulfoniumtriflat werden in 18,7 g Cyclopentanon gelöst. Die Lösung wird durch einen Teflon-Filter mit einer Porengrösse von 0,2 µm filtriert und anschliessend auf einen Siliziumwafer (100 mm) aufgeschleudert. Nach dem Ausheizen auf der Heizplatte (60 s, 130 °C) wird ein Resistfilm mit einer Dicke von 723 nm erhalten. Die Belichtung wird mit einem 5:1 Projektionsbelichtungsgerät (NA 0,37, Canon FPA 4500) bei einer Wellenlänge von 248 nm in Belichtungschritten von 1 mJ/cm² im optimalen Fokus durchgeführt. Nach dem Ausheizen auf der Heizplatte (60 s, 120 °C) wird der belichtete Wafer 60 Sekunden in einer 0,262 N wässrigen Tetramethylammoniumhydroxidlösung entwickelt.
Es wird ein positives Abbild der Strukturierungsmaske erhalten. Bei einer Belichtungsdosis von 16 mJ/cm² sind Subhalbmirometer-Strukturen mit steilen Kanten aufgelöst.

## Patentansprüche

1. Polymer mit einem Molekulargewicht (Gewichtsmittel) M_{w} von 10³ bis 10⁶ enthaltend wiederkehrende Struktureinheiten der Formeln (I), (IIa) und (Ilb) 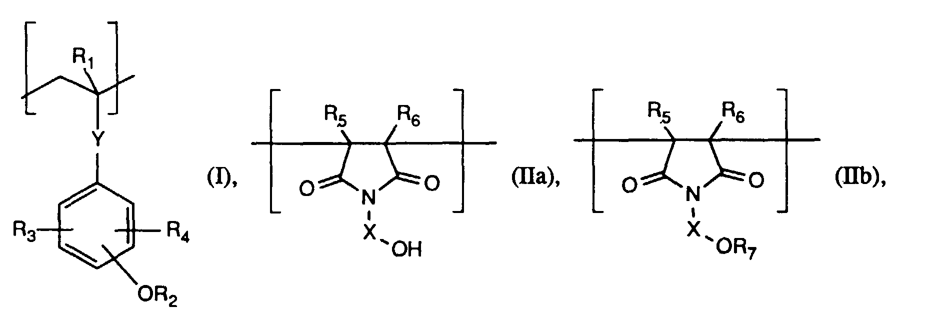 worin R₁ Wasserstoff oder Methyl bedeutet, Y für eine direkte Bindung oder einen zweiwertigen Rest der Formel (III) steht, 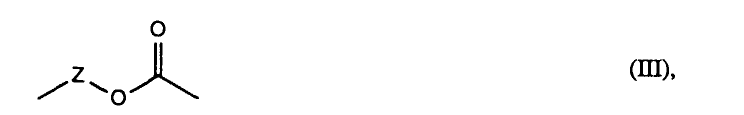 worin Z eine an den Phenylkern gebundene C₁-C₆-Alkylengruppe bedeutet,
OR₂ einen säurespaltbaren Rest darstellt,
worin R₂ C₄-C₁₀-tert.-Alkyl, unsubstituiertes oder durch eine oder mehrere C₁-C₆-Alkylgruppen, C₁-C₆-Alkoxygruppen oder Halogenatome substituiertes Allyl, Cyclohex-2-enyl, C₆-C₁₄-Aryl oder C₇-C₁₆-Aralkyl, Trialkylsilyl,
oder eine Gruppe der Formeln (IV)-(VII) darstellt, 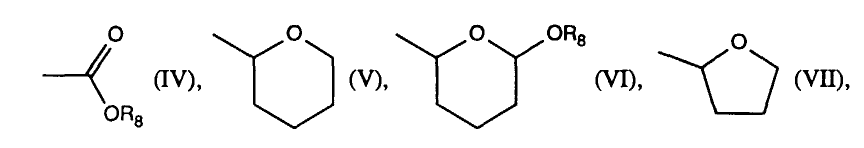 worin
R₈ C₁-C₆-Alkyl oder unsubstituiertes oder durch eine oder mehrere C₁-C₆-Alkylgruppen, C₁-C₆-Alkoxygruppen oder Halogenatome substituiertes C₆-C₁₄-Aryl oder C₇-C₁₆-Aralkyl bedeutet,
R₃ und R₄ unabhängig voneinander für Wasserstoff, C₁-C₆-Alkylgruppen, C₁-C₆-Alkoxygruppen oder Halogenatome stehen,
R₅ und R₆ unabhängig voneinander Wasserstoff oder Methyl bedeuten,
X für C₁-C₆-Alkylen und R₇ für C₁-C₆-Alkyl, unsubstituiertes oder durch eine oder mehrere C₁-C₆-Alkylgruppen, C₁-C₆-Alkoxygruppen oder Halogenatome substituiertes C₆-C₁₄-Aryl oder C₇-C₁₆-Aralkyl oder für -CO-R₈ steht, worin R₈ die gleiche Bedeutung wie in Formel (IV) hat.

2. Polymer gemäss Anspruch 1, enthaltend wiederkehrende Strukturelemente der Formel (I), worin R₁, R₃ und R₄ Wasserstoff bedeuten, Y eine direkte Bindung darstellt und R₂ für C₄-C₁₀-tert.-Alkyl, Trimethylsilyl, unsubstituiertes oder durch eine oder mehrere C₁-C₆-Alkylgruppen substituiertes Allyl, Cylohex-2-enyl oder eine Gruppe der Formeln (IV)-(VII) steht, worin R₈ C₁-C₄-Alkyl oder Phenyl bedeutet.

3. Polymer gemäss Anspruch 1, enthaltend wiederkehrende Strukturelemente der Formel (I), worin R₁, R₃ und R₄ Wasserstoff bedeuten, Y eine direkte Bindung darstellt und R₂ für tert.-Butyl, tert.-Butoxycarbonyl, 3-Methylbut-2-enyl oder die Gruppe der Formel (V) steht.

4. Polymer gemäss Anspruch 1, enthaltend wiederkehrende Strukturelemente der Formel (IIa), worin R₅ und R₆ Wasserstoff bedeuten und X für Methylen steht.

5. Polymer gemäss Anspruch 1, enthaltend wiederkehrende Strukturelemente der Formel (IIb), worin R₅ und R₆ Wasserstoff bedeuten, R₇ für C₁-C₄-Alkyl, Phenyl oder -CO-R₈ steht, worin R₈ C₁-C₄-Alkyl oder Phenyl ist, und X Methylen, Ethylen, Trimethylen oder Tetramethylen bedeutet.

6. Polymer gemäss Anspruch 1, enthaltend wiederkehrende Strukturelemente der Formel (IIb), worin R₅ und R₆ Wasserstoff bedeuten, R₇ für Methyl oder Acetyl steht und X Methylen oder Ethylen ist.

7. Polymer gemäss Anspruch 1, enthaltend 10-75 mol-%, bevorzugt 20-50 mol-%, Struktureinheiten der Formel (IIa) und 25-90 mol-%, bevorzugt 50-80 mol-%, Struktureinheiten der Formel (IIb), bezogen auf 100 mol-% Struktureinheiten der Formel (I).

8. Strahlungsempfindliche Zusammensetzung enthaltend
a) mindestens ein Polymer gemäss Anspruch 1 und
b) mindestens eine unter der Einwirkung von aktinischer Strahlung säurebildende Verbindung.

9. Zusammensetzung gemäss Anspruch 8, enthaltend als weitere Komponente c) ein Lösungsmittel oder ein Lösungsmittelgemisch.

10. Zusammensetzung gemäss Anspruch 8, enthaltend als Komponente b) mindestens eine Verbindung der Formel (VIII)
(Ar₁)_{q}(Z₁)ᵣ(Z₂)ₛ S^{⊕} X₁^{⊖} (VIII),
worin
Ar₁ unsubstituiertes oder durch Halogen, C₁-C₄-Alkyl, C₁-C₄-Alkoxy, -OH und/oder Nitro substituiertes Phenyl, Naphthyl oder Phenyl-COCH₂- ist,
Z₁ C₁-C₆-Alkyl oder C₃-C₇-Cycloalkyl und
Z₂ Tetrahydrothienyl, Tetrahydrofuryl oder Hexahydropyryl sind,
q für 0, 1, 2 oder 3,
r für 0, 1 oder 2 und
s für 0 oder 1 stehen, wobei die Summe q+r+s 3 beträgt, und
X₁^{⊖} ein Chlorid-, Bromid- oder Iodidanion, BF₄^{⊖}, PF₆^{⊖}, AsF₆^{⊖}, SbF₆^{⊖}, FSO^{⊖} oder das Anion einer organischen Sulfonsäure oder Carbonsäure ist.

11. Zusammensetzung gemäss Anspruch 10, worin Ar₁ Phenyl bedeutet, q die Zahl 3 ist, r und s Null sind, und X₁^{⊖} SbF₆^{⊖}, AsF₆^{⊖}, PF₆^{⊖}, CF₃SO₃^{⊖}, C₂F₅SO₃^{⊖}, n-C₃F₇SO₃^{⊖}, n-C₄F₉SO₃^{⊖}, n-C₆F₁₃SO₃^{⊖}, n-C₈F₁₇SO₃^{⊖} oder C₆F₅SO₃^{⊖} darstellt

12. Zusammensetzung gemäss Anspruch 10, worin die Komponente b) Triphenylsulfoniumtrifluormethansulfonat ist.

13. Zusammensetzung gemäss Anspruch 8, enthaltend 0,1-20 Gew.-%, vorzugsweise 1-10 Gew.-%, der Komponente b), bezogen auf das Gewicht der Komponente a).

14. Verwendung der Zusammensetzung gemäss Anspruch 8 als Positiv-Photoresist.

15. Die unter Verwendung der Zusammensetzung gemäss Anspruch 8 hergestellten Schutzschichten und Reliefstrukturen.

## Claims

1. Polymer having a molecular weight (average weight) M_{W} of from 10³ to 10⁶ comprising structural repeating units of formulae (I), (IIa) and (IIb) 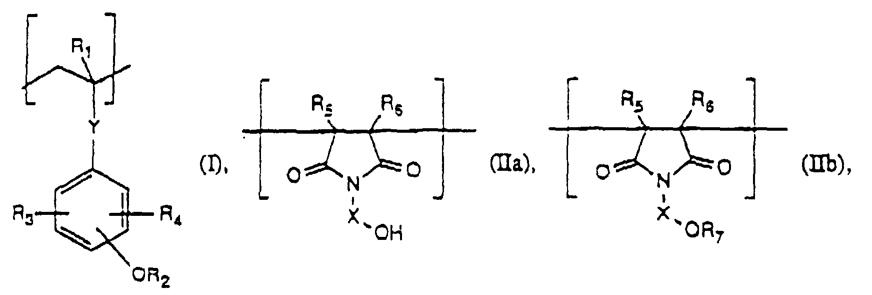 wherein R₁ is hydrogen or methyl, Y is a direct bond or a bivalent residue of formula (III) 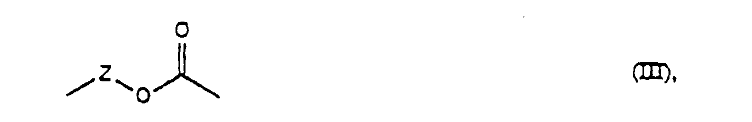 wherein Z is a C₁-C₆alkylene group bonded to the phenyl nucleus, OR₂ is an acid-cleavable residue,
wherein R₂ is C₄-C₁₀tert-alkyl, or is allyl, cyclohex-2-enyl, C₆-C₁₄aryl or C₇-C₁₆aralkyl, either unsubstituted or substituted by one or more C₁-C₆alkyl groups, C₁-C₆alkoxy groups or halogen atoms, or is trialkylsilyl or a group of formulae (IV)-(VII) 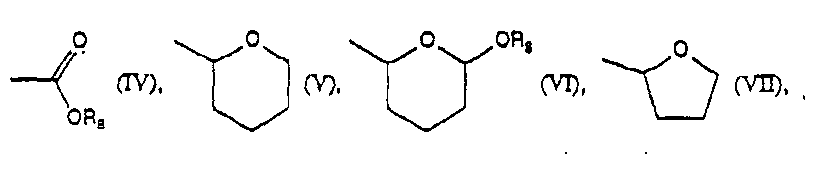 wherein
R₈ is C₁-C₆alkyl, or is C₆-C₁₄aryl or C₇-C₁₆aralkyl, unsubstituted or substituted by one or more C₁-C₆alkyl groups, C₁-C₆alkoxy groups or halogen atoms,
R₃ and R₄ are, independently of one another, hydrogen, C₁-C₆alkyl groups, C₁-C₆alkoxy groups or halogen atoms,
R₅ and R₆ are, independently of one another, hydrogen or methyl,
X is C₁-C₆alkylene and R₇ is C₁-C₆alkyl, or is C₆-C₁₄aryl or C₇-C₁₆aralkyl, unsubstituted or substituted by one or more C₁-C₆alkyl groups, C₁-C₆alkoxy groups or halogen atoms, or is -CO-R₈, wherein R₈ has the same meaning as in formula (IV).

2. Polymer according to Claim 1, comprising structural repeating units of formula (I), wherein R₁, R₃ and R₄ are hydrogen, Y is a direct bond and R₂ is C₄-C₁₀tert-alkyl or trimethylsilyl, or is allyl which is unsubstituted or substituted by one or more C₁-C₆alkyl groups, or is cyclohex-2-enyl or a group of formulae (IV)-(VII), wherein R₈ is C₁-C₄alkyl or phenyl.

3. Polymer according to Claim 1, comprising structural repeating units of formula (I), wherein R₁, R₃ and R₄ are hydrogen, Y is a direct bond and R₂ is tert-butyl, tert-butoxycarbonyl, 3-methylbut-2-enyl or the group of formula (V).

4. Polymer according to Claim 1, comprising structural repeating units of formula (IIa), wherein R₅ and R₆ are hydrogen and X is methylene.

5. Polymer according to Claim 1, comprising structural repeating units of formula (IIb), wherein R₅ and R₆ are hydrogen, R₇ is C₁-C₄alkyl, phenyl or -CO-R₈, wherein R₈ is C₁-C₄alkyl or phenyl, and X is methylene, ethylene, trimethylene or tetramethylene.

6. Polymer according to Claim 1, comprising structural repeating units of formula (IIb), wherein R₅ and R₆ are hydrogen, R₇ is methyl or acetyl and X is methylene or ethylene.

7. Polymer according to Claim 1, comprising from 10 to 75 mol %, preferably from 20 to 50 mol %, of structural units of formula (IIa) and from 25 to 90 mol %, preferably from 50 to 80 mol %, of structural units of formula (IIb), based on 100 mol % of structural units of formula (I).

8. Radiation-sensitive composition comprising
a) at least one polymer according to Claim 1 and
b) at least one compound that forms acid under the action of actinic radiation.

9. Composition according to Claim 8, comprising a solvent or a solvent mixture as a further component c).

10. Composition according to Claim 8, comprising as component b) at least one compound of formula (VIII)
(Ar₁)_{q}(Z₁)ᵣ(Z₂)ₛ S^{⊕}X₁^{⊖} (VIII)
wherein
Ar₁ is phenyl, naphthyl or phenyl-COCH₂-, each of which is unsubstituted or substituted by halogen, C₁-C₄alkyl, C₁-C₄alkoxy, -OH and/or by nitro,
Z₁ is C₁-C₆alkyl or C₃-C₇cycloalkyl and
Z₂ is tetrahydrothienyl, tetrahydrofuryl or hexahydropyryl,
q is 0, 1, 2 or 3,
r is 0, 1 or 2 and
s is 0 or 1, the sum of q+r+s being 3, and
X₁^{⊖} is a chloride, bromide or iodide anion, BF₄^{⊖}, PF₆^{⊖}, AsF₆^{⊖}, SbF₆^{⊖}, FSO^{⊖} or the anion of an organic sulphonic acid or carboxylic acid.

11. Composition according to Claim 10, wherein Ar₁ is phenyl, q is the integer 3, r and s are zero, and X₁^{⊖} is SbF₆^{⊖}, AsF₆^{⊖}, PF₆^{⊖}, CF₃SO₃^{⊖}, C₂F₅SO₃^{⊖}, n-C₃F₇SO₃^{⊖}, n-C₄F₉SO₃^{⊖}, n-C₆F₁₃SO₃^{⊖}, n-C₈F₁₇SO₃^{⊖} or C₆F₅SO₃^{⊖}.

12. Composition according to Claim 10, wherein component b) is triphenylsulphonium trifluoromethanesulphonate.

13. Composition according to Claim 8, comprising from 0.1 to 20 % by weight, preferably from 1 to 10 % by weight, of component b), based on the weight of component a).

14. Use of the composition according to Claim 8 as a positive photoresist.

15. The protective layers and relief structures manufactured using the composition according to Claim 8.

## Revendications

1. Polymère ayant une masse moléculaire (moyenne en poids) Mₚ de 10³ à 10⁶, contenant des unités structurales répétées des formules (I), (IIa) et (IIb) 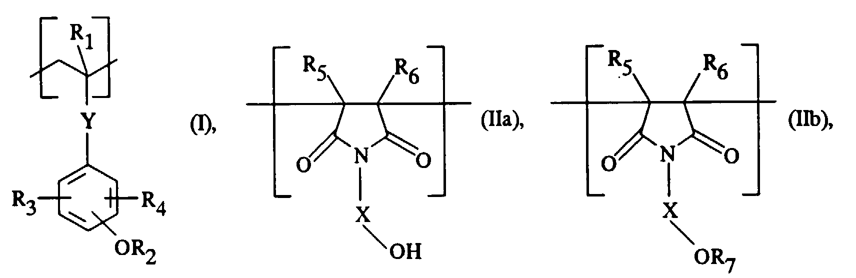 dans lesquelles R₁ représente hydrogène ou méthyle, Y représente une liaison directe ou un reste divalent de formule (III) 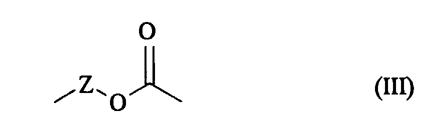 dans laquelle Z représente un groupe alkylène en C₁-C₆ lié au noyau phényle, OR₂ représente un reste clivable par un acide dans lequel R₂ représente tert-alkyle en C₄-C₁₀, allyle, cyclohex-2-ényle, aryle en C₆-C₁₄ ou aralkyle en C₇-C₁₆ non substitué ou substitué par un ou plusieurs groupes alkyle en C₁-C₆, groupes alcoxy en C₁-C₆ ou atomes d'halogène, trialkylsilyle, ou un groupe des formules (IV)-(VII) 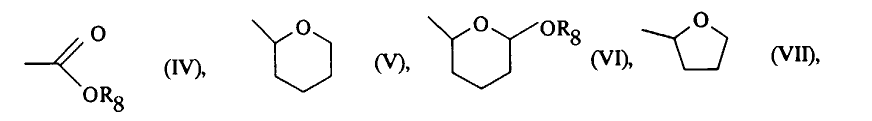 dans lesquelles R₈ représente alkyle en C₁-C₆ ou aryle en C₆-C₁₄ ou aralkyle en C₇-C₁₆ non substitué ou substitué par un ou plusieurs groupes alkyle en C₁-C₆, groupes alcoxy en C₁-C₆ ou atomes d'halogène,
R₃ et R₄ représentent indépendamment l'un de l'autre l'hydrogène, des groupes alkyle en C₁-C₆, des groupes alcoxy en C₁-C₆ ou des atomes d'halogène,
R₅ et R₆ représentent indépendamment l'un de l'autre hydrogène ou méthyle,
X représente alkylène en C₁-C₆ et R₇ représente alkyle en C₁-C₆, aryle en C₆-C₁₄ ou aralkyle en C₇-C₁₆ non substitué ou substitué par un ou plusieurs groupes alkyle en C₁-C₆, groupes alcoxy en C₁-C₆ ou atomes d'halogène ou représente -CO-R₈ où R₈ a la même signification que dans la formule (IV).

2. Polymère selon la revendication 1, contenant des éléments structuraux répétés de formule (I) où R₁, R₃ et R₄ représentent l'hydrogène, Y représente une liaison directe et R₂ représente tert-alkyle en C₄-C₁₀, triméthylsilyle, allyle non substitué ou substitué par un ou plusieurs groupes alkyle en C₁-C₆, cyclohex-2-ényle ou un groupe des formules (IV)-(VII) où R₈ représente alkyle en C₁-C₄ ou phényle.

3. Polymère selon la revendication 1, contenant des éléments structuraux répétés de formule (I) où R₁, R₃ et R₄ représentent l'hydrogène, Y représente une liaison directe et R₂ représente tert-butyle, tert-butoxycarbonyle, 3-méthylbut-2-ényle ou le groupe de formule (V).

4. Polymère selon la revendication 1, contenant des éléments structuraux répétés de formule (IIa) où R₅ et R₆ représentent l'hydrogène et X représente méthylène.

5. Polymère selon la revendication 1, contenant des éléments structuraux répétés de formule (IIb) où R₅ et R₆ représentent l'hydrogène, R₇ représente alkyle en C₁-C₄, phényle ou -CO-R₈ où R₈ représente alkyle en C₁-C₄ ou phényle, et X représente méthyle, éthylène, triméthylène ou tétraméthylène.

6. Polymère selon la revendication 1, contenant des éléments structuraux répétés de formule (IIb) où R₅ et R₆ représentent l'hydrogène, R₇ représente méthyle ou acétyle et X représente méthylène ou éthylène.

7. Polymère selon la revendication 1, contenant 10 à 75 mol %, de préférence 20 à 50 mol %, d'unités structurales de formule (IIa) et 25 à 90 mol %, de préférence 50 à 80 mol %, d'unités structurales de formule (IIb) par rapport à 100 mol % d'unités structurales de formule (I).

8. Composition sensible aux rayonnements contenant
a) au moins un polymère selon la revendication 1 et
b) au moins un composé formateur d'acide sous l'action d'un rayonnement actinique.

9. Composition selon la revendication 8, contenant comme constituant supplémentaire c) un solvant ou un mélange de solvants.

10. Composition selon la revendication 8, contenant comme composant b) au moins un composé de formule (VIII)
(Ar₁)_{q}(Z₁)ᵣ(Z₂)ₛS^{⊕}X₁^{⊖} (VIII)
dans laquelle
Ar₁ représente phényle, naphtyle ou phényl-COCH₂ non substitué ou substitué par halogène, alkyle en C₁-C₄, alcoxy en C₁-C₄, et/ou nitro,
Z₁ représente alkyle en C₁-C₆ ou cycloalkyle en C₃-C₇ et
Z₂ représente tétrahydrothiényle, tétrahydrofuryle ou hexahydropyryle,
q représente 0, 1, 2 ou 3,
r représente 0, 1 ou 2 et
s représente 0 ou 1, la somme q+r+s étant égale à 3, et
X₁^{⊖} représente un anion chlorure, bromure ou iodure, BF₄^{⊖}, PF₆^{⊖}, AsF₆^{⊖}, SbF₆^{⊖}, FSO^{⊖} ou l'anion d'un acide sulfonique organique ou d'un acide carboxylique.

11. Composition selon la revendication 10, dans laquelle Ar₁ représente phényle, q est le nombre 3, r et s sont nuls, et X₁^{⊖} représente SbF₆^{⊖}, AsF₆^{⊖}, PF₆^{⊖}, CF₃SO₃^{⊖}, C₂F₅SO₃^{⊖}, n-C₃F₇SO₃^{⊖}, n-C₄F₉SO₃^{⊖}, n-C₆F₁₃SO₃^{⊖}, n-C₈F₁₇SO₃^{⊖} ou C₆F₅SO₃^{⊖}.

12. Composition selon la revendication 10, dans laquelle le composant b) est le trifluorométhanesulfonate de triphénylsulfonium.

13. Composition selon la revendication 8, contenant 0,1 à 20 % en masse, de préférence 1 à 10 % en masse, de composant b), par rapport à la masse du composant a).

14. Utilisation de la composition selon la revendication 8 comme photorésist positif.

15. Couches de protection et structures de relief préparées au moyen de la composition selon la revendication 8.
